# EUROPÄISCHE PATENTSCHRIFT

(11) **EP 3 123 576 B1**
(45) Veröffentlichungstag und Bekanntmachung des Hinweises auf die Patenterteilung: **28.04.2021**
(21) Anmeldenummer: 15715179.6
(22) Anmeldetag: 19.03.2015
(51) Int. Cl.: H02B 1/28

(54) **GEHÄUSE, INSBESONDERE EIN INDUSTRIEGEHÄUSE**
HOUSING, IN PARTICULAR AN INDUSTRIAL HOUSING
BOÎTIER, EN PARTICULIER UN BOÎTIER INDUSTRIEL

(30) Priorität: 24.03.2014 DE 102014104006
(43) Veröffentlichungstag der Anmeldung: 01.02.2017
(73) Patentinhaber: Phoenix Contact GmbH & Co. KG, 32825 Blomberg (DE)
(72) Erfinder: LÖBOWITZ, Torben, 32657 Lemgo (DE); GRIMM, Axel, 32839 Steinheim (DE)
(74) Vertreter: Muth, Bruno
(86) Internationale Anmeldenummer: PCT/EP2015/055784
(87) Internationale Veröffentlichungsnummer: WO 2015/144554

(56) Entgegenhaltungen:
- DE-C- 952 284
- FR-A1- 2 808 409
- JP-A- H04 259 286
- JP-A- 2004 146 284
- JP-A- 2011 250 543
- US-A- 4 699 293

## Beschreibung

Die Erfindung betrifft ein Gehäuse, insbesondere ein Industriegehäuse.

Derartige Industriegehäuse können beispielsweise als Schaltschränke, Klemmenkästen und dergleichen für elektrische Schaltgeräte, Verbinder, Klemmen usw. z. B für Maschinensteuerung, Verteilungen, Gebäudeinstallationen verwendet werden. Sie weisen üblicherweise einen Gehäusegrundkörper auf, wobei eine Seitenfläche des Gehäusegrundkörpers offen ausgebildet sein kann, um einen Zugang zu dem Gehäuseinnenraum zwecks Montage, Wartung, Einstellarbeiten usw. zur Verfügung stellen zu können.

Diese offen ausgebildete Seitenfläche kann mit einer Tür verschlossen werden. An einer oder mehreren anderen Seitenfläche kann der Gehäusegrundkörper ferner eine oder mehrere Öffnungen beispielsweise für Kabeldurchführungen aufweisen, welche jeweils mit einem Abdeckelement, beispielsweise einer Flanschplatte, verschlossen werden können.

Diese Gehäuse werden in unterschiedlichen Umgebungsbedingungen eingesetzt, so dass sie bestimmten Schutzarten beispielsweise gegen Eindringen von Feuchtigkeit und Staub und auch gegen Einwirkung von mechanischen Belastungen entsprechen müssen. Insbesondere die mit einem Abdeckelement verschlossene Öffnung an einer der Seitenflächen des Gehäusegrundkörpers stellt hier oftmals eine Schwachstelle dar. Die JPH04259286 offenbart den Oberbegriff des Anspruchs 1.

Der Erfindung liegt die Aufgabe zu Grunde, ein Gehäuse zur Verfügung zu stellen, welches im Bereich der durch ein Abdeckelement verschlossenen Öffnung einen verbesserten Schutz ermöglichen kann.

Die Lösung der Aufgabe erfolgt erfindungsgemäß mit den Merkmalen des Anspruchs 1. Zweckmäßige Ausgestaltungen und vorteilhafte Weiterbildungen der Erfindung sind in den Unteransprüchen angegeben.

Das erfindungsgemäß vorgesehene Gehäuse weist einen Gehäusegrundkörper auf, wobei an mindestens einer Seitenfläche des Gehäusegrundkörpers eine Öffnung ausgebildet ist. Ferner weist das Gehäuse ein Dichtungselement auf, welches derart auf der die Öffnung aufweisenden Seitenfläche aufgelegt ist, dass das Dichtungselement die Öffnung umrandet. Weiter weist das Gehäuse ein Rahmenelement auf, welches derart auf der die Öffnung aufweisenden Seitenfläche des Gehäusegrundkörpers aufgelegt ist, dass das Rahmenelement das Dichtungselement umrandet. Zudem weist das Gehäuse ein Abdeckelement zum Verschließen der Öffnung auf, welches in einem verschlossenen Zustand der Öffnung auf dem Rahmenelement und dem Dichtungselement flächig aufliegt. Um den verschlossenen Zustand auszubilden, ist das Abdeckelement mittels Befestigungsmitteln an dem Gehäusegrundkörper befestigbar, wobei in dem verschlossenen Zustand die Befestigungsmittel durch das Abdeckelement und das Dichtungselement hindurchgeführt sind.

Das Gehäuse gemäß der Erfindung zeichnet sich insbesondere dadurch aus, dass nunmehr auch das Dichtungselement, welches zwischen dem Gehäusegrundkörper und dem Abdeckelement angeordnet ist, vor äußeren Einwirkungen geschützt ist, so dass die Dichtwirkung des Dichtungselementes bei äußeren Einwirkungen auf das Gehäuse geschützt ist und damit die Dichtwirkung des Dichtungselementes aufgrund von äußeren Einwirkungen auf das Gehäuse nicht negativ beeinflusst wird. Erreicht wird dies erfindungsgemäß dadurch, dass ein Rahmenelement um das Dichtungselement herumgelegt ist und damit das Dichtungselement an seiner Außenumfangsfläche von dem Rahmenelement umschlossen ist. Das Dichtungselement ist dadurch nach außen hin durch das Rahmenelement insbesondere vor mechanischen Einwirkungen und auch beispielsweise vor Strahlwasser geschützt. Sowohl das Dichtungselement als auch das Rahmenelement liegen dabei flächig auf der Seitenfläche des Gehäusegrundkörpers auf, wobei in einem verschlossenen Zustand der Öffnung das Abdeckelement die Öffnung, das Dichtungselement und das Rahmenelement überdeckt. Dadurch, dass das Rahmenelement und das Dichtungselement benachbart zueinander auf der Seitenfläche des die Öffnung aufweisenden Gehäusegrundkörpers aufliegen, werden im verschlossenen Zustand der Öffnung die von dem Abdeckelement in Richtung des Gehäusegrundkörpers wirkenden Kräfte, aufgrund der Befestigung des Abdeckelementes an dem Gehäusegrundkörper, auf das Rahmenelement abgeleitet, so dass die auf das Dichtungselement wirkenden Kräfte und damit die Belastungen für das Dichtungselement reduziert werden können. Eine gute und sichere Dichtwirkung des Dichtungselementes kann dadurch für einen langen Zeitraum gewährleistet werden.

Bevorzugt ist es vorgesehen, dass in dem verschlossenen Zustand das Abdeckelement mit seiner Außenumfangsfläche bündig mit der Außenumfangsfläche des Rahmenelementes abschließt. Kanten zwischen dem Abdeckelement und dem Rahmenelement, an welchen sich beispielsweise Schmutz ablagern oder Feuchtigkeit stauen kann, können dadurch verhindert werden.

Um insbesondere eine besonders gute Widerstandsfähigkeit gegenüber mechanischen Einwirkungen erreichen zu können, ist das Rahmenelement vorzugsweise aus einem formstabilen Material ausgebildet. Durch die Ausbildung des Rahmenelementes aus einem formstabilen Material kann damit auch ein besonders effektiver Schutz des Dichtungselementes erreicht werden, da verhindert werden kann, dass auf das Rahmenelement wirkende Belastungen auf das Dichtungselement übertragen werden können.

Beispielsweise kann das Rahmenelement aus einem Metall, insbesondere einem Edelstahl, ausgebildet sein. Ist das Rahmenelement aus einem Edelstahl ausgebildet, kann eine besonders hohe Korrosionsbeständigkeit des Rahmenelementes erreicht werden. Das Rahmenelement kann aber auch aus anderen Metallmaterialien, wie Stahlblech oder Aluminium, ausgebildet sein. Ferner können auch Metallmaterialien eingesetzt werden, welche zum Schutz gegen Korrosion verzinkt, vernickelt oder lackiert sind.

Das Rahmenelement kann beispielsweise fest an der Seitenfläche des Gehäusegrundkörpers oder aber auch fest an dem Abdeckelement befestigt sein. Die Befestigung kann beispielsweise mittels einer Klebeverbindung oder einer Schweißverbindung, beispielsweise einer Punktschweißverbindung, ausgebildet sein.

Das Dichtungselement ist bevorzugt aus einem elastischen Material, insbesondere einem offenporigen Silikonschaum, ausgebildet. Durch die Verwendung eines offenporigen Silikonschaums ist eine partiell besonders hohe Kompression des Dichtungselementes möglich, da offenporiger Silikonschaum einen sehr guten Druckverformungsrest (DVR) aufweist. Zudem kann durch die Verwendung eines offenporigen Silikonschaums für das Dichtungselement ein besonders hoher Temperaturbereich abgedeckt werden, da offenporiger Silikonschaum auch unter extremen Temperaturbedingungen, insbesondere zwischen -60°C und +160°C, sehr gut abdichtet und die Funktionsfähigkeit über die Lebensdauer halten kann. Das Dichtungselement kann aber auch aus anderen elastischen Materialien, wie geschlossenporiger Silikonschaum, Polyurethanschaum oder Neoprenschaum, ausgebildet sein.

Um die Dichtwirkung des Dichtungselementes weiter erhöhen zu können, ist es bevorzugt vorgesehen, dass in einem nicht verschlossenen Zustand der Öffnung das Dichtungselement eine größere Höhe aufweist als das Rahmenelement. Wird die Öffnung mittels des Abdeckelementes verschlossen, kann dann beim Auflegen des Abdeckelementes auf das Dichtungselement das Dichtungselement von dem Abdeckelement derart weit zusammengedrückt bzw. gestaucht werden, bis das Abdeckelement auf dem Rahmenelement zum Aufliegen kommt. Durch das Zusammendrücken des Dichtungselements kann eine besonders dichte, flächige Anlage des Dichtungselementes an dem Abdeckelement und auch an der Seitenfläche des Gehäusegrundkörpers erreicht werden, wodurch eine besonders gute Dichtwirkung hin zu dem Abdeckelement und dem Gehäusegrundkörper erzielt werden kann. In dem verschlossenen Zustand der Öffnung weist das Dichtungselement durch das Zusammendrücken des Dichtungselements vorzugsweise die gleiche Höhe auf wie das Rahmenelement.

Das Abdeckelement weist vorzugsweise mehrere Bohrungen auf, über welche die Befestigungsmittel hindurchgeführt sein können. Das Dichtungselement weist vorzugsweise ebenfalls mehrere Durchgangsöffnungen auf, durch welche die Befestigungsmittel hindurchgeführt sein können. Als Befestigungsmittel können beispielsweise Schrauben verwendet werden, welche in an dem Gehäusegrundkörper ausgebildete Gewindelöcher eingeschraubt werden können. Andere Befestigungsmittel sind ebenfalls denkbar.

Nachfolgend wird die Erfindung unter Bezugnahme auf die anliegenden Zeichnungen anhand einer bevorzugten Ausführungsform näher erläutert.

### Es zeigen:

- Fig. 1: eine schematische perspektivische Darstellung eines Gehäuses gemäß der Erfindung in einem nicht verschlossenen Zustand,
- Fig. 2: eine schematische seitliche Draufsicht auf ein wie in Fig. 1 gezeigtes Gehäuse,
- Fig. 3: eine schematische Darstellung des in Fig. 1 und 2 gezeigten Gehäuses in einem verschlossenen Zustand mit dem Abdeckelement in einer teilweise geschnittenen Darstellung, und
- Fig. 4: eine schematische Darstellung des in Fig. 1 und 2 gezeigten Gehäuses in einem verschlossenen Zustand.

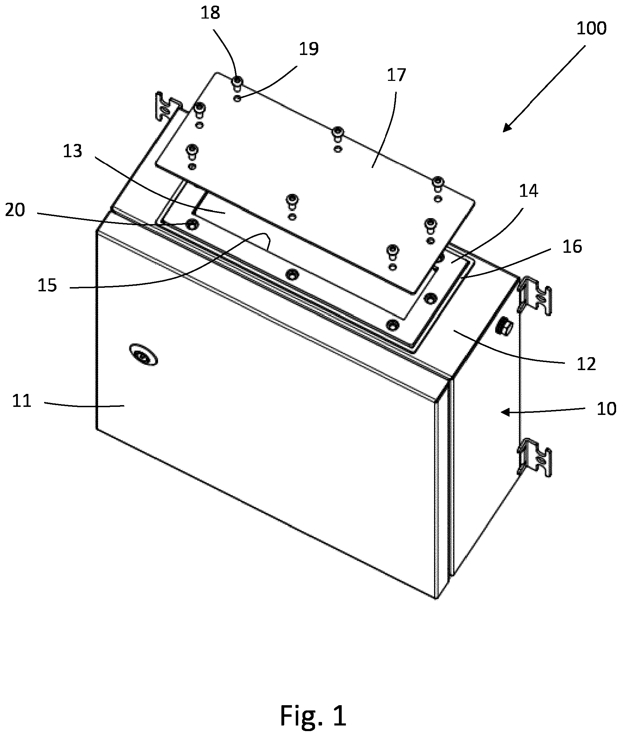

Fig. 1 zeigt ein Gehäuse 100 in Form eines Industriegehäuses zur Aufnahme von beispielsweise elektrischen Schaltmitteln. Das Gehäuse 100 weist einen Gehäusegrundkörper 10 auf, welcher kastenförmig ausgebildet ist. Der Gehäusegrundkörper 10 kann aus einem Metallmaterial, insbesondere einem Edelstahlmaterial, ausgebildet sein. Eine Seitenfläche des Gehäuses 100 ist offen ausgebildet, an welcher eine Tür 11 angeordnet ist, um diese offen ausgebildete Seitenfläche verschließen zu können.

Eine andere Seitenfläche 12 des Gehäusegrundkörpers 10 weist eine Öffnung 13 auf, welche ebenfalls einen Zugang zu dem Innenraum des Gehäusegrundkörpers 10 ermöglicht. Auf der die Öffnung 13 aufweisenden Seitenfläche 12 ist ein Dichtungselement 14 derart flächig aufgelegt, dass das Dichtungselement 14, welches aus einem elastischen Material, beispielsweise einem offenporigen Silikonschaum, ausgebildet ist, die Öffnung 13 umrandet bzw. umschließt. Das plattenförmig, eben ausgebildete Dichtungselement 14 weist hierfür eine mittig des Dichtungselementes 14 angeordnete Aussparung 15 auf, wobei die Größe der Aussparung 15 der Größe der Öffnung 13 an der Seitenfläche 12 des Gehäusegrundkörpers 10 entspricht.

Bei der hier gezeigten Ausgestaltung sind die Grundfläche des Dichtungselementes 14 sowie der Aussparung 15 rechteckförmig ausgebildet. Andere Formen des Dichtungselementes 14 bzw. der Aussparung 15 und auch der Öffnung, wie beispielsweise rund oder andere mehreckige Formen sind ebenfalls möglich.

Die Aussparung 15 ist derart in dem Dichtungselement 14 ausgebildet, dass die Breite des Dichtungselementes 14 zwischen der Aussparung 15 und der Außenumfangsfläche des Dichtungselementes 14 an allen Seiten des Dichtungselementes 14 gleich groß ist, um zu allen Seiten des Dichtungselementes 14 eine gleich gute Dichtwirkung erreichen zu können.

Zusätzlich zu dem Dichtungselement 14 ist ein Rahmenelement 16 flächig auf der Seitenfläche 12 des Gehäusegrundkörpers 10 derart aufgelegt, dass das Rahmenelement 16 die Außenumfangsfläche des Dichtungselementes 14 umrandet bzw. umschließt. Im Gegensatz zu dem Dichtungselement 14 ist das Rahmenelement 16 aus einem formstabilen Material, insbesondere einem Metallmaterial, wie Edelstahl, ausgebildet. Das Rahmenelement 16 umrahmt somit das Dichtungselement 14, wobei das Rahmenelement 16 mit seiner Innenumfangsfläche unmittelbar an der Außenumfangsfläche des Dichtungselementes 14 anliegen kann.

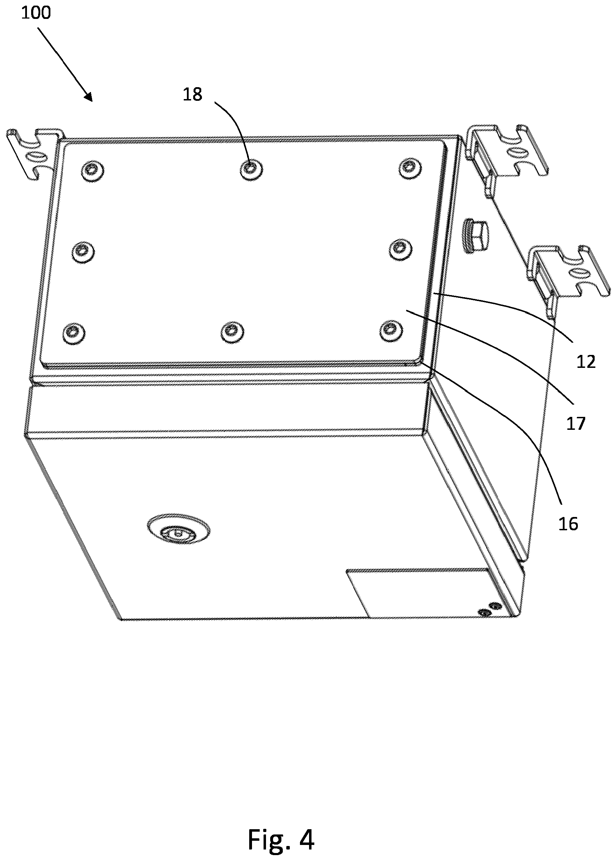

Zum Verschließen der Öffnung 13 der Seitenfläche 12 des Gehäusegrundkörpers 10 wird ein Abdeckelement 17 flächig auf das Dichtungselement 14 und das Rahmenelement 16 aufgelegt, so dass das Abdeckelement 17 das Dichtungselement 14 und das Rahmenelement 16 überdeckt. Das Abdeckelement 17 ist hier plattenförmig ausgebildet. Die Außenumfangsfläche des Abdeckelementes 17 entspricht dabei der Außenumfangfläche des Rahmenelementes 16, so dass in einem verschlossenen Zustand der Öffnung 13, wie es in Fig. 4 gezeigt ist, das Abdeckelement 17 bündig mit dem Rahmenelement 16 abschließt. Im Gegensatz zu dem Dichtungselement 14 weist das Abdeckelement 17 damit eine größere Außenumfangsfläche auf als das Dichtungselement 14. Befestigt wird das Abdeckelement 17 an dem Gehäusegrundkörper 10 mittels mehreren Befestigungsmitteln 18, welche hier in Form von Schrauben ausgebildet sind. Das Abdeckelement 17 weist mehrere Bohrungen 19 und das Dichtungselement 14 weist mehrere Durchgangsöffnungen 20 auf, wobei die Befestigungsmittel 18 durch die Bohrungen 19 in dem Abdeckelement 17 und durch die Durchgangsöffnungen 20 in dem Dichtungselement 14 hindurchgeführt werden, um in an dem Gehäusegrundkörper 10 ausgebildete Gewindebohrungen befestigt, insbesondere verschraubt, werden zu können.

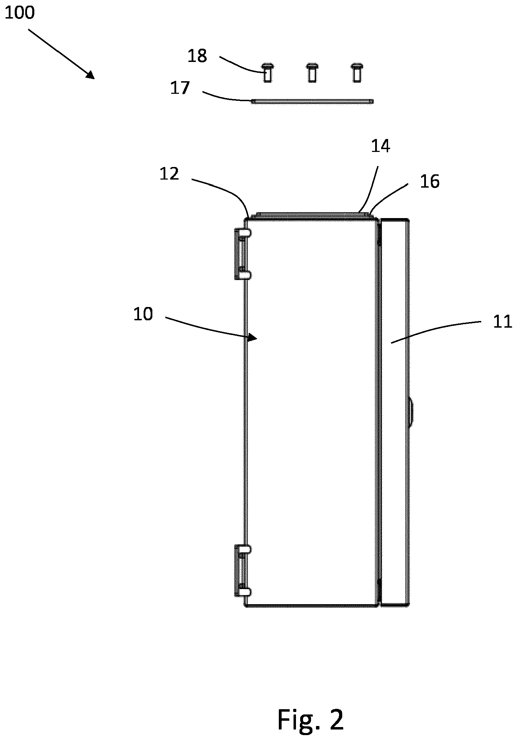

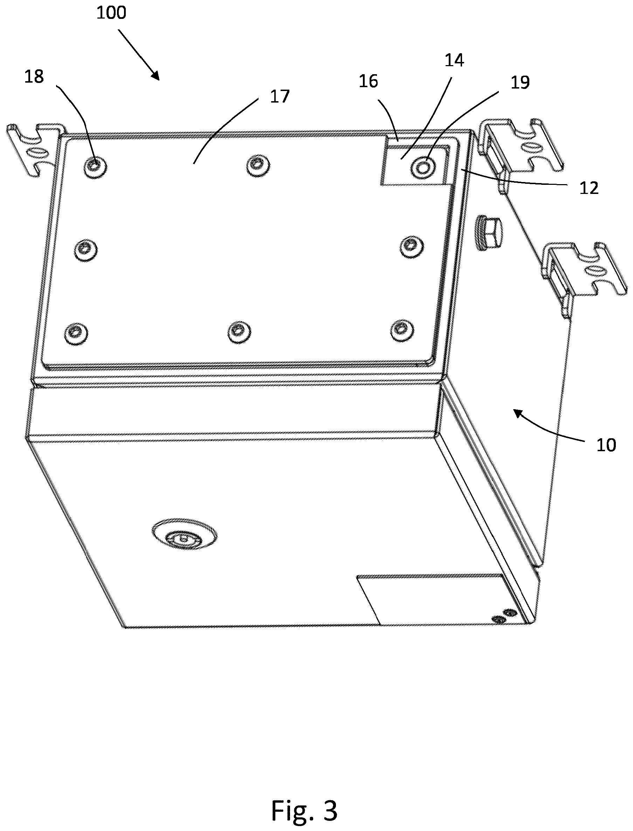

Wie insbesondere in Fig. 2 zu erkennen ist, weist das Dichtungselement 14 in einem nicht verschlossenen Zustand der Öffnung 13 eine größere Höhe auf als das Rahmenelement 16, so dass das Dichtungselement 14 das Rahmenelement 16 überragt. Im verschlossenen Zustand der Öffnung 13 ist das Dichtungselement 14 durch das Auflegen des Abdeckelementes 17 zusammengedrückt bzw. gestaucht, so dass die Höhe des Dichtungselementes 14 im Vergleich zu dem nicht verschlossenen Zustand reduziert ist. Das Dichtungselement 14 wird von dem Abdeckelement 17 derart weit zusammengedrückt, bis das Abdeckelement 17 auf dem Rahmenelement 16 flächig aufliegt. Die Höhe des Dichtungselementes 14 entspricht dann im verschlossenen Zustand der Öffnung 13 mittels des Abdeckelementes 17 der Höhe des Rahmenelementes 16, wie dies in Fig. 3 bei der teilweise geschnittenen Darstellung des Abdeckelementes 17 zu erkennen ist.

**Bezugszeichenliste**

| | |
|---|---|
| Gehäuse | 100 |
| Gehäusegrundkörper | 10 |
| Tür | 11 |
| Seitenfläche | 12 |
| Öffnung | 13 |
| Dichtungselement | 14 |
| Aussparung | 15 |
| Rahmenelement | 16 |
| Abdeckelement | 17 |
| Befestigungsmittel | 18 |
| Bohrung | 19 |
| Durchgangsöffnung | 20 |

## Patentansprüche

1. Gehäuse (100),
mit einem Gehäusegrundkörper (10), wobei an mindestens einer Seitenfläche (12) des Gehäusegrundkörpers (10) eine Öffnung (13) ausgebildet ist,
mit einem Dichtungselement (14), welches derart auf der die Öffnung (13) aufweisenden Seitenfläche (12) aufgelegt ist, dass das Dichtungselement (14) die Öffnung (13) umrandet,
mit einem Rahmenelement (16), welches derart auf der die Öffnung (13) aufweisenden Seitenfläche (12) aufgelegt ist, dass das Rahmenelement (16) das Dichtungselement (14) umrandet, und
mit einem Abdeckelement (17) zum Verschließen der Öffnung (13), welches in einem verschlossenen Zustand der Öffnung (13) auf dem Rahmenelement (16) und dem Dichtungselement (14) flächig aufliegt, wobei das Abdeckelement (17) mittels Befestigungsmitteln (18) an dem Gehäusegrundkörper (10) befestigbar ist,
**dadurch gekennzeichnet, dass** in dem verschlossenen Zustand die Befestigungsmittel (18) durch das Abdeckelement (17) und das Dichtungselement (14) hindurchgeführt sind.

2. Gehäuse (100) nach Anspruch 1, **dadurch gekennzeichnet, dass** in dem verschlossenen Zustand das Abdeckelement (17) mit seiner Außenumfangsfläche bündig mit der Außenumfangsfläche des Rahmenelementes (16) abschließt.

3. Gehäuse (100) nach Anspruch 1 oder 2, **dadurch gekennzeichnet, dass** das Rahmenelement (16) aus einem formstabilen Material ausgebildet ist.

4. Gehäuse (100) nach einem der Ansprüche 1 bis 3, **dadurch gekennzeichnet, dass** das Rahmenelement (16) aus einem Metall, insbesondere einem Edelstahl, ausgebildet ist.

5. Gehäuse (100) nach einem der Ansprüche 1 bis 4, **dadurch gekennzeichnet, dass** das Dichtungselement (14) aus einem elastischen Material, insbesondere einem offenporigen Silikonschaum, ausgebildet ist.

6. Gehäuse (100) nach einem der Ansprüche 1 bis 5, **dadurch gekennzeichnet, dass** in einem nicht verschlossenen Zustand der Öffnung das Dichtungselement (14) eine größere Höhe aufweist als das Rahmenelement (16).

## Claims

1. Housing (100),
having a housing base body (10), wherein an opening (13) is formed on at least one side surface (12) of the housing base body (10),
having a seal element (14) which is placed on the side surface (12) comprising the opening (13) in such a way that the seal element (14) borders the opening (13), having a frame element (16) which is placed on the side surface (12) comprising the opening (13) in such a way that the frame element (16) borders the seal element (14), and
having a cover element (17) which is intended to close the opening (13) and which, in a closed state of the opening (13), is placed areally on the frame element (16) and the seal element (14), wherein the cover element (17) can be fastened to the housing base body (10) by way of fastening means (18),
**characterized in that**, in the closed state, the fastening means (18) are guided through the cover element (17) and the seal element (14).

2. Housing (100) according to Claim 1, **characterized in that**, in the closed state, the outer peripheral surface of the cover element (17) terminates flush with the outer peripheral surface of the frame element (16).

3. Housing (100) according to Claim 1 or 2, **characterized in that** the frame element (16) is formed from a dimensionally stable material.

4. Housing (100) according to one of Claims 1 to 3, **characterized in that** the frame element (16) is formed from a metal, in particular a high-grade steel.

5. Housing (100) according to one of Claims 1 to 4, **characterized in that** the seal element (14) is formed from an elastic material, in particular an open-pored silicone foam.

6. Housing (100) according to one of Claims 1 to 5, **characterized in that**, in a non-closed state of the opening, the seal element (14) has a greater height than the frame element (16).

## Revendications

1. Boîtier (100), comprenant
un corps de base de boîtier (10), une ouverture (13) étant ménagée sur au moins une surface latérale (12) du corps de base de boîtier (10),
un élément d'étanchéité (14) qui est placé sur la surface latérale (12) comportant l'ouverture (13) de telle sorte que l'élément d'étanchéité (14) borde l'ouverture (13),
un élément de cadre (16) qui est placé sur la surface latérale (12) comportant l'ouverture (13) de telle sorte que l'élément de cadre (16) borde l'élément d'étanchéité (14), et un élément de recouvrement (17) destiné à fermer l'ouverture (13) et venant en appui à plat sur l'élément de cadre (16) et l'élément d'étanchéité (14) lorsque l'ouverture (13) est fermée, l'élément de recouvrement (17) pouvant être fixé au corps de base de boîtier (10) à l'aide de moyens de fixation (18), **caractérisé en ce que**, à l'état fermé, les moyens de fixation (18) sont guidés à travers l'élément de recouvrement (17) et l'élément d'étanchéité (14).

2. Boîtier (100) selon la revendication 1, **caractérisé en ce que**, à l'état fermé, l'élément de recouvrement (17) vient, avec sa surface périphérique extérieure, à fleur de la surface périphérique extérieure de l'élément de cadre (16).

3. Boîtier (100) selon la revendication 1 ou 2, **caractérisé en ce que** l'élément de cadre (16) est formé à partir d'un matériau dimensionnellement stable.

4. Boîtier (100) selon l'une des revendications 1 à 3, **caractérisé en ce que** l'élément de cadre (16) est en métal, notamment en acier fin.

5. Boîtier (100) selon l'une des revendications 1 à 4, **caractérisé en ce que** l'élément d'étanchéité (14) est formé à partir d'un matériau élastique, notamment d'une mousse de silicone à pores ouverts.

6. Boîtier (100) selon l'une des revendications 1 à 5, **caractérisé en ce que**, lorsque l'ouverture n'est pas fermée, l'élément d'étanchéité (14) a une hauteur supérieure à celle de l'élément de cadre (16).
